# EUROPÄISCHE PATENTSCHRIFT

(11) **EP 0 643 366 B1**
(45) Veröffentlichungstag und Bekanntmachung des Hinweises auf die Patenterteilung: **13.02.2002**
(21) Anmeldenummer: 94111975.2
(22) Anmeldetag: 01.08.1994
(51) Int. Cl.: G06K 19/077, H01L 21/48

(54) **Elektronisches Modul für Karten und Herstellung eines solchen Moduls**
Electronic modul for cards and production of such module
Module électronique de carte et production d'un tel module

(30) Priorität: 10.08.1993 DE 4326816
(43) Veröffentlichungstag der Anmeldung: 15.03.1995
(73) Patentinhaber: Giesecke & Devrient GmbH, 81677 München (DE)
(72) Erfinder: Haghiri-Tehrani, Yahya, D-80797 München (DE)
(74) Vertreter: Klunker . Schmitt-Nilson . Hirsch

(56) Entgegenhaltungen:
- EP-A- 0 128 822
- EP-A- 0 213 974
- EP-A- 0 299 530
- EP-A- 0 321 326
- DE-A- 3 424 241
- US-A- 4 674 175

## Beschreibung

Die Erfindung betrifft ein Verfahren zur Herstellung eines elektronischen Moduls für Datenträger mit wenigstens einem integrierten Schaltkreis, mit Kontaktflächen für die Kommunikation des integrierten Schaltkreises mit externen Geräten und mit einer auf der dem integrierten Schaltkreis zugewandten Seite auf den Kontaktflächen aufliegenden elektrisch isolierenden Schicht, die zur elektrischen Verbindung der Kontaktflächen mit dem elektrischen Schaltkreis Aussparungen aufweist. Die Erfindung betrifft ferner nach dem Verfahren hergestellte Module.

Aus der US-PS 4,674,175 ist bereits ein Verfahren zur Herstellung von elektronischen Modulen bekannt, bei dem zunächst ein mit einer Vielzahl von runden Öffnungen versehenes Metallband bereitgestellt wird. In die Öffnungen ragen jeweils zwei sich gegenüberliegende Reihen von Metallzungen, auf denen ein aus elektrisch isolierendem Material bestehendes Plättchen derart be-festigt wird, daß im Plättchen befindliche Aussparungen auf die Metallzungen führen. Im Zentrum des Plättchens zwischen den Reihen der Metallzungen befindet sich ein Aufnahmeraum, in den ein integrierter Schaltkreis eingebracht und leitend mit den Metallzungen verbunden wird, wobei die leitenden Verbindungen durch die Aussparungen in dem Plättchen geführt werden. Danach werden der integrierte Schaltkreis und die leitenden Verbindungen mit einer Gußmasse vergossen. Hierbei dient das Plättchen als Fließstop für die Gußmasse in Richtung der Metallzungen, so daß keine Gußmasse auf die Metallzungen fließen kann. Schließlich wird das fertiggestellte Modul aus dem Metallband ausgestanzt. Die auf der Oberfläche des Moduls liegenden Metallzungen dienen als Kontaktflächen.

Das in der US-PS 4,674,175 vorgestellte Verfahren ermöglicht die Herstellung flacher elektronischer Module, da der integrierte Schalkreis in einen Aufnahmeraum des Plättchens eingebracht wird. Das Plättchen selbst besteht aus einem synthetischen Material und wird in Spritzgußtechnik gefertigt, wobei die Aussparungen zur Hindurchführung der leitenden Verbindungen und der Aufnahmeraum für den integrierten Schaltkreis beim Spritzgießen bereits berücksichtigt werden.

Es ist, z. B. aus der DE-PS 34 24 241, ferner ein Verfahren zur Herstellung von elektronischen Modulen bekannt, bei dem zunächst ein Trägerfilm bereitgestellt wird. In diesen Trägerfilm werden Aussparungen zur Hindurchführung von leitenden Verbindungen und eine Aussparung zur Aufnahme eines integrierten Schaltkreises eingestanzt. Danach wird der Trägerfilm mit einer leitenden Beschichtung versehen, in der Kontaktflächen durch Unterbrechungen derart gebildet werden, daß die Aussparungen zur Hindurchführung der leitenden Verbindungen unterhalb der Kontaktflächen liegen und auf diese führen. Zwischen den Kontaktflächen verbleibt ein Teil der leitenden Beschichtung, der die Aussparung für den Schaltkreis in Richtung der Kontaktflächen abdeckt. In einem weiteren Schritt wird der integrierte.Schaltkreis in die dafür vorgesehene Aussparung eingebracht und auf den Teil der leitenden Beschichtung, der zwischen den umliegenden Kontaktflächen liegt, aufgeklebt. Schließlich wird der Schaltkreis mit den Kontaktflächen leitend verbunden, wobei die Verbindungen durch die umliegenden Aussparungen hindurchgeführt werden. Auch hier werden der Schaltkreis und die leitenden Verbindungen mit einer Gußmasse vergossen. Dabei dient der Trägerfilm als Fließstop für die Gußmasse in Richtung der Kontaktflächen.

Es hat sich gezeigt, daß es für unterschiedliche Typen integrierter Schaltkreise und für integrierte Schaltkreise unterschiedlicher Größe je nach Verbindungstechnik zwischen den Anschlüssen des Schaltkreises und den Kontaktflächen eine optimale Lage der Aussparungen in der isolierenden Schicht (bzw. Plättchen oder Trägerfilm) gibt, die den elektrischen Zugang zu den Kontaktflächen ermöglichen. Befindet sich der integrierte Schaltkreis in einer Aussparung, so ist auch diese in den Abmaßen der Größe des jeweiligen Schaltkreises anzupassen. Das heißt, daß bei den bekannten Verfahren für jeden Schaltkreis und für Schaltkreise unterschiedlicher Größe entsprechende Spritzgußwerkzeuge zur Fertigung des Plättchens bzw. entsprechende Stanzwerkzeuge zum Stanzen der Aussparungen im Trägerfilm bereitzustellen sind, die es erlauben, ein optimal an den jeweiligen Schaltkreis angepaßtes Plättchen bzw. einen optimal angepaßten Trägerfilm zu erzeugen. Dies beeinträchtigt nicht nur die Flexibilität bei der Herstellung.von elektronischen Modulen sondern verursacht auch wegen der Herstellung jeweils neuer Werkzeuge entsprechende Kosten, die sich in den Kosten für das elektronische Modul niederschlagen.

Der Erfindung liegt deshalb die Aufgabe zugrunde, ein Verfahren zur Herstellung von elektronischen Modulen vorzustellen, das eine kostengünstige Herstellung des Moduls bei gleichzeitig hoher Flexibilität bezüglich der Verwendung verschiedener integrierter Schaltkreise erlaubt.

Die Aufgabe wird durch die im kennzeichnenden Teil der Ansprüche 1 und 10 angegebenen Merkmale gelöst.

Der Grundgedanke der Erfindung besteht darin, ein standardisiertes Ausgangsprodukt zur Verfügung zu stellen, das aus einer elektrisch isolierenden Schicht mit einem darauf befindlichen, an sich beliebig gestalteten Kon-taktlayout besteht. Je nach Typ des zu verarbeitenden. Schaltkreises werden in die isolierende Schicht des Aus-gangsprodukts wenigsten die für die elektrische Verbindung des Schaltkreises mit den Kontaktflächen notwendigen Aussparungen eingebracht.

Wesentlich für den Erfolg ist, daß die Aussparungen in das standardisierte Ausgangsprodukt mit einer Technik eingebracht werden, die bei Verwendung des gleichen Werkzeuges eine einfache Anpassung der Lage der herzustellenden Aussparungen an unterschiedliche Schaltkreise ermöglicht.

Die mit der Erfindung erzielten Vorteile bestehen insbesondere darin, daß die Herstellung von elektronischen Modulen mit unterschiedlichen Schaltkreisen durch die Verwendung eines standardisierten Ausgangsprodukts wesentlich flexibler gestaltet werden kann. Die Anpassung der Lage der herzustellenden Aussparungen kann besonders einfach mit einem programmgesteuerten Werkzeug vorgenommen werden, da zur Erzeugung von in der Lage unterschiedlichen Aussparungen lediglich das Steuerprogramm für das Werkzeug zu ändern ist. Der Aufwand dafür ist aber gering. Es braucht also für die Herstellung unterschiedlicher Module nur ein Werkzeug bereitgestellt zu werden. Ferner kann das Standardprodukt in großen Massen hergestellt werden, da es für alle in das Modul einzubauenden integrierten Schaltkreistypen gleich ist. Aus allem folgt, daß durch die Verwendung eines standardisierten Ausgangsprodukts, in das die Aussparungen durch ein programmgesteuertes Werkzeug eingebracht werden, eine kostengünstigere Herstellung von elektronischen Modulen möglich ist.

Gemäß einer bevorzugten Ausführungsform der Erfindung werden die Aussparungen für die elektrischen Verbindungen des Schaltkreises mit den Kontaktflächen in die Isolierschicht des Ausgangsprodukts durch ein programmgesteuertes Fräswerkzeug eingebracht. Im Steuerteil des Fräswerkzeuges können hierbei mehrere Programme für unterschiedliche Schaltkreistypen und somit für unterschiedlich gelegene Aussparungen gespeichert werden, die gegebenenfalls als Steuerprogramme für das Werkzeug benutzt werden. Darüber hinaus ist es möglich, beim Erstellen der Aussparungen in der Isolierschicht in die Kontaktflächen hineinzufräsen, womit sichergestellt ist, daß man einen nichtkorrodierten Bereich auf den Kontaktflächen erhält, was die Herstellung eines leitenden Übergangs zwischen den Kontaktflächen und den leitenden Verbindungen zwischen den Kontaktflächen und dem Schaltkreis wesentlich vereinfacht.

Weitere Ausführungsformen und Vorteile der Erfindung ergeben sich aus den Unteranspüchen und der nachfolgenden Beschreibung an Hand der Zeichnungen. Darin zeigen
- Fig. 1: eine Ausweiskarte in Draufsicht
- Fig. 2: einen Ausschnitt aus der Fig. 1 in Draufsicht
- Fig. 3: einen Ausschnitt aus der Fig. 1 in Draufsicht
- Fig. 4: ein standardisierten Ausgangsprodukt im Querschnitt
- Fig. 5: ein standardisiertes Ausgangsprodukt im Querschnitt mit eingefrästen Aussparungen
- Fig. 6: ein fertiggestelltes Modul im Querschnitt
- Fig. 7: ein fertiggestelltes Modul im Querschnitt
- Fig. 8: ein fertiggestelltes Modul im Querschnitt
- Fig. 9: ein fertiggestelltes Modul im Querschnitt

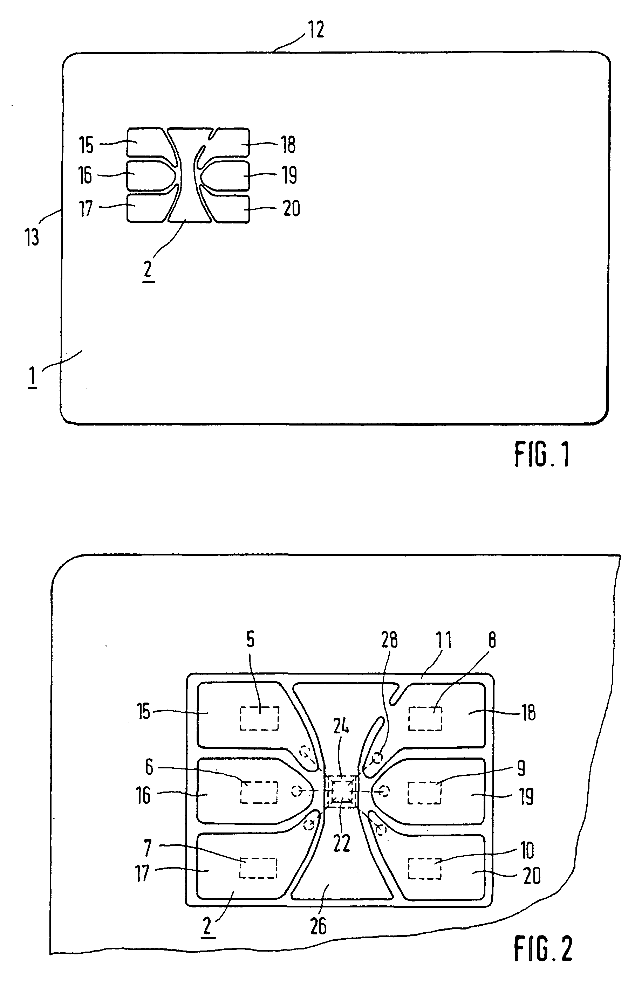

Figur 1 zeigt eine Ausweiskarte mit eingebautem elektronischen Modul 2 in Draufsieht. Auf dem elektronischen Modul 2 befinden sich die Kontaktflächen 15 bis 20, die zusammen ein Kontaktlayout bilden, das weitestgehend beliebig gestaltet werden kann. Wenn die Ausweiskarte zur Kommunikation mit einem externen Gerät in dieses eingeschoben wird, so wird sie dort so positioniert, daß die Kontaktstifte auf definierten Bereichen der Kontaktflächen 15 bis 20 aufliegen.

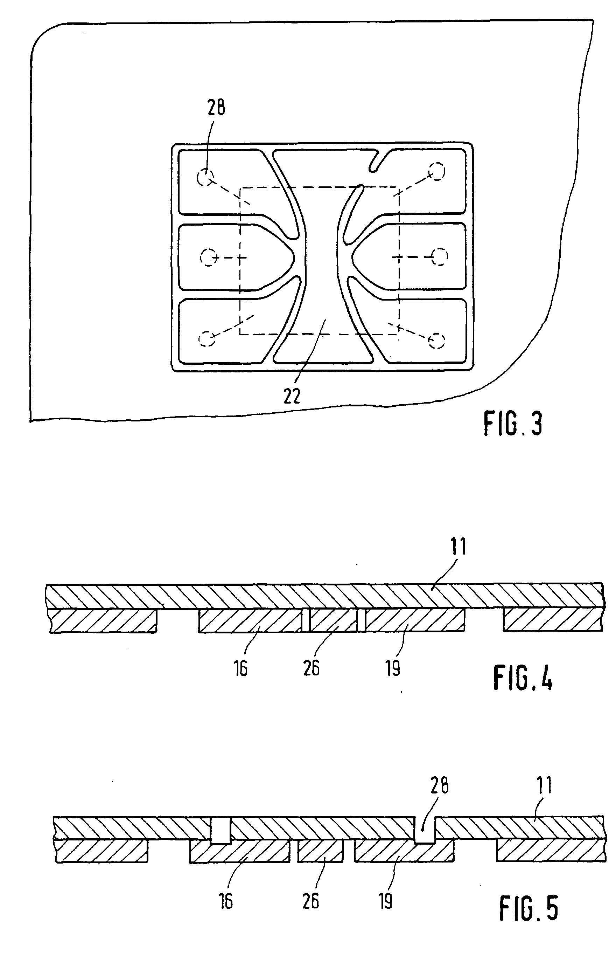

Figur 2 zeigt einen vergrößerten, nicht maßstabsgetreuen Ausschnitt aus der Figur 1 mit einem beispielhaften Design der Oberfläche des elektronischen Moduls 2. Die isolierende Schicht 11 des Moduls 2 ist weitestgehend mit einer leitenden Beschichtung bedeckt, in der durch Unterbrechungen die Kontaktflächen 15 bis 20 ausgebildet sind. Die für die Kontaktierung in einem externen Gerät notwendigen leitenden Flächen 5 bis 10 sind in den Kontaktflächen 15 bis 20 strichliniert dargestellt. Der integrierte Schaltkreis 22 des Moduls 2 befindet sich in einer Aussparung 24 der isolierenden Schicht 11, die in Richtung der Kontaktflächen durch einen zwischen den Kontaktflächen liegenden Steg 26 abgedeckt ist. Unterhalb jeder der Kontaktflächen 15 bis 20 befindet sich in der isolierenden Schicht eine Aussparung 28, durch die jeweils eine leitende Verbindung vom Schaltkreis 22 zur entsprechenden Kontaktfläche geführt wird. Die Lage der Aussparungen 28 ist abhängig von der Größe des Schaltkreises 22 und von der Art, wie die leitenden Verbindungen zwischen dem Schaltkreis 22 und den Kontaktflächen 15 bis 20 erstellt werden.

In Figur 3 ist weitestgehend das gleiche Modul wie in Figur 2 gezeigt. Der in das elektronische Modul 2 eingebaute integrierte Schaltkreis 22 ist hier allerdings wesentlich größer ausgebildet als der in Figur 2 gezeigte. Dementsprechend liegen die Aussparungen 28 näher am äußeren Rand des Kontaktlayouts als in der Figur 2. Auch hier liegt der Schaltkreis in einer Aussparung, die.jedoch einen dünnen Boden aufweist, der die Aussparung in Richtung der Kontaktflächen abdeckt. Sowohl in der Figur 2 als auch in der Figur 3 liegen die Aussparungen 28 nicht direkt unterhalb der leitenden Flächen 5 bis 10, die zur Kontaktierung in einem externen Gerät notwendig sind, sondern vielmehr in einem Bereich, der durch die beliebige Ausgestaltung der Kontaktflächen 15 bis 20 entsteht.

Die Figur 4 zeigt das standardisierte Ausgangsprodukt in Endlosform im Querschnitt. Das Ausgangsprodukt, bestehend aus einer isolierenden Schicht 11, auf der sich das Kontaktlayout befindet, kann auf verschiedene Arten hergestellt werden. Beispielsweise kann die isolierende Schicht 11 als endloser Trägerfilm vorliegen, der zunächst mit einer ganzflächigen leitenden Beschichtung versehen wird, in der das Kontaktlayout durch Unterbrechungen (z. B. in Ätztechnik erstellt) ausgebildet wird. Entsprechende Verfahren sind bekannt und brauchen hier nicht näher erläutert werden. Der Trägerfilm kann z. B. weitestgehend einem handelsüblichen Film entsprechen, der am Rand Perforationen aufweist, die zum Transport des Films zu den einzelnen Verarbeitungsstation genutzt werden. Es kann aber auch ein Trägerfilm verwendet werden, der keine Perforationen aufweist.

Es ist aber auch möglich, zunächst ein perforiertes Metallband bereitzustellen und in diesem das Kontaktlayout durch Stanzen zu erzeugen, wobei es zunächst noch über dünne Stege mit dem Band verbünden bleibt. Das so vorbereitete Metallband wird nunmehr ganzflächig oder partiell mit einer isolierenden Schicht 11 versehen. Diese Schicht kann beispielsweise aufgeklebt oder angespritzt werden und sehr dünn ausgebildet werden, da in diesem Fall das Metallband als Transportmittel zu den einzelnen Verarbeitungsstationen genutzt werden kann.

In dem standardisierten Ausgangsprodukt werden die Aussparungen 28, die auf die Kontaktflächen führen, mit Hilfe eines Fräswerkzeuges erzeugt, wie es Figur 5 zeigt. Dabei wird geringfügig in die Kontaktflächen hineingefräst, so daß dort Bereiche entstehen, die sicher nichtkorridiert sind. Abhängig von dem in das Modul einzubauenden Schaltkreistyp haben die Aussparungen 28 eine unterschiedliche Lage (siehe dazu auch Figuren 2 und 3). Der Bereich, in dem das Fräswerkzeug die Aussparungen 28 erzeugt, wird durch das Steuerprogramm festgelegt, welches das Fräswerkzeug steuert. Selbstverständlich können die Aussparungen 28 auch durch ein anderes Werkzeug, z. B. mit Hilfe eines Bohrers oder Lasers, in die isolierende Schicht 11 eingebracht werden, wichtig ist lediglich, daß das verwendete Werkzeug durch ein Programm zu steuern ist. Am Rand des standardisierten Ausgangsprodukts können zusätzlich zu den Aussparungen 28 auch Perforationen eingefräst werden, die später zum Transport des Ausgangsproduktes zu den verschiedenen Verarbeitungsstationen genutzt werden können. Das gleichzeitige Erstellen der Aussparungen 28 und der Perforationen hat den Vorteil, daß die Perforationen lagerichtig zu den Aussparungen 28 liegen und das Ausgangsprodukt später sehr genau positioniert werden kann. Die gleiche Wirkung erziele man natürlich, wenn man die Perforation in der ersten Verarbeitungsstation durch Stanzung erzeugt.

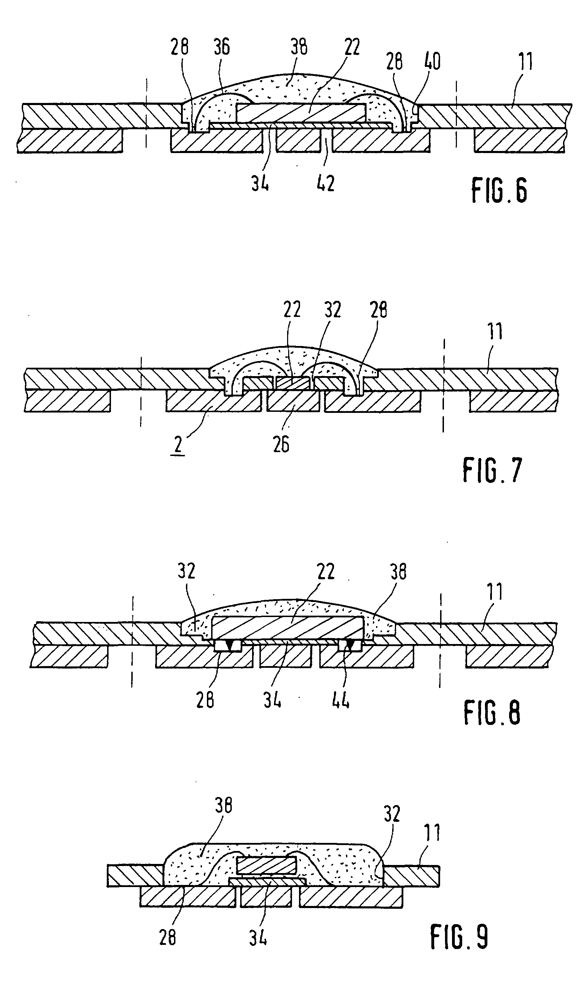

Die Figur 6 zeigt das fertiggestellte Modul im Querschnitt. In einer Aussparung 32, die ebenfalls durch Fräsen erstellt wird, wird der integrierte Schaltkreis 22 eingeklebt und danach werden leitende Verbindungen 36 zwischen dem integrierten Schaltkreis 22 und den Kontaktflächen erstellt, die durch die Aussparungen 28 auf die nichtkorridierten Kontaktflächen geführt werden. Dies stellt einen leitenden Übergang zwischen den leitenden Verbindungen 36 und den Kontaktflächen weitestgehend sicher. Im gezeigten Beispiel sind die leitenden Verbindungen 36 als Bonddrähtchen ausgebildet, sie können aber auch in anderer Art und Weise, beispielsweise durch eine Metallspinne oder leitende Kontakthöcker, die auf dem integrierten Schaltkreis liegen und aus einem leitenden Kunststoff bzw. einem leitenden Kleber oder Lack bestehen, erzeugt werden. Schließlich wird die Aussparung 32 mit einer Gußmasse 38 vergossen, die den Schaltkreis 32 und die Bonddrähtchen 36 vor mechanischen Belastungen schützt. Die seitliche Begrenzung 40 der Aussparung dient hier als Begrenzungsrahmen für die Gußmasse, so daß ein seitliches Abfließen der noch nicht erhärteten Gußmasse auf die isolierende Schicht vermieden wird. Ein Abfließen der Gußmasse durch die Spalte 42 in Richtung der Kontaktflächen wird durch den Boden.34 der Aussparung 32 vermieden.

Da der Boden 34 lediglich als Fließstopp für die Gußmasse dient, kann er eine extrem geringe Restdicke von einigen µm aufweisen. Derart dünne Böden sind mit einem Fräswerkzeug besonders gut zu erstellen, da die Fräsgenauigkeit im Bereich weniger µm liegt. Somit können elektronische Module mit einer extrem geringen Bauhöhe hergestellt werden. Weist die isolierende Schicht 11 von vornherein eine extrem geringe Dicke auf, so kann auf die Aussparung 32 verzichtet und der Schaltkreis direkt auf die Schicht aufgeklebt werden.

Figur 7 zeigt ein elektronisches Modul mit einem kleinen integrierten Schaltkreis 22, wie es bereits in Figur 2 in Draufsicht gezeigt ist. Das elektronische Modul 2 wird weitestgehend genauso erzeugt, wie das in Figur 6 gezeigte Modul. Am Anfang steht also wiederum das in Figur 4 gezeigte Ausgangsprodukt, in das die Fenster 28 zur Hindurchführung der leitenden Verbindungen vom Schaltkreis zu den Kontakflächen und gegebenenfalls (d. h. wenn eine dicke isolierende Schicht vorliegt) die Aussparung 32 für den Schaltkreis 22 eingefräst wird. Bei kleinen Schaltkreisen 22 kann die Aussparung 32 ohne Boden ausgebildet werden, da die Aussparung 32 in Richtung der Kontaktflächen durch den Steg 26 abgedeckt wird. Hierbei ist es möglich, beim Erzeugen der Aussparung 32 in den Steg 26 hineinzufräsen, wodurch die Bauhöhe des fertiggestellten Moduls nochmals verringert werden kann. Wenn der integrierte Schaltkreis so groß ist, daß er zum Teil unterhalb der zur Kontaktierung notwendigen Flächen 5 - 10 liegt, kann der Steg 26 nicht als Boden der Aussparung 32 genutzt werden, da er von diesen Flächen isoliert sein muß und somit nicht mehr breit genug ausgebildet werden kann (siehe auch Fig. 3).

Bei der Herstellung des in Figur 7 gezeigten Moduls 2 braucht lediglich ein anderes Steuerprogramm für das Fräswerkzeug verwendet werden, da die Aussparungen 28 eine andere Lage haben als bei dem in Figur 6 gezeigten Modul. Nach dem Einbringen der Aussparungen in die isolierende Schicht 11 wird das in Figur 7 gezeigte Modul genauso fertiggestellt wie das in Figur 6 gezeigte.

Fig. 8 zeigt ein elektronisches Modul mit einem integrierten Schaltkreis, auf dem sich Kontakthöcker zur Erstellung der leitenden Verbindungen mit den Kontaktflächen befinden. Auch dieses Modul wird weitestgehend genauso wie das in Fig. 6 gezeigte Modul erzeugt. Am Anfang steht also das in Fig. 4 gezeigte Ausgangsprodukt, in das die Fenster 28 und gegebenenfalls die Aussparung 32 für den Schaltkreis 22 eingefräst wird. Der Schaltkreis 22 wird so in die Aussparung 32 eingelegt, daß die Kontakthöcker 44 durch die Aussparungen 28 in der isolierenden Schicht 11 ragen und auf den Kontaktflächen zu liegen kommen. Der Bodenbereich 34 der. Aussparung 32 kann wiederum extrem dünn ausgebildet werden, so daß die Kontaktflächen 44 nur eine geringe Höhe aufzuweisen brauchen, um durch die Fenster 28 auf die Kontaktflächen geführt werden zu können. Nach dem Einbringen des Schaltkreises 22 in die Aussparung wird der Schaltkreis mit einer Gußmasse 38 vergossen. Das fertiggestellte Modul ist von geringer Bauhöhe.

Fig. 9 zeigt ein elektronisches Modul, das ebenfalls weitestgehend wie das in der Fig. 6 gezeigte Modul gefertigt wird. Am Anfang steht also ebenfalls das in Fig. 4 gezeigte Ausgangsprodukt, in dessen isolierende Schicht 11 die Aussparung 32 eingefräst wird, so daß nur noch ein Boden 34 von geringer Restdicke verbleibt. Ferner werden die Aussparungen 28 zur Hindurchführung der leitenden Verbindungen vom Schaltkreis zu den Kontaktflächen eingefräst. Hierbei werden die Aussparungen 28 so erzeugt, daß eine möglichst große Fläche zu den Kontaktflächen frei von dem Material der Isolierschicht 11 ist, d. h. die Aussparungen werden möglichst nahe am Schaltkreis erzeugt und schließen mit dem Außenrand der Aussparung 32 ab. Dadurch wird erreicht, daß die Gußmasse 38 in einem großen Bereich, nämlich im Bereich der Aussparung 28, recht dick und in sich stabil ist und ein guter Verbund zwischen der Gußmasse und der Metallschicht der Kontaktflächen entsteht.

Besonders vorteilhaft ist es, wenn die isolierende Schicht 11 aus einem Material gebildet wird, das ohne zusätzliche Kleber direkt mit dem Material des Kartenkörpers, in den das elektronische Modul eingebracht wird, verbunden werden kann. Als Materialien kommen z. B. PVC-, ABS- oder PC-Schichten in Frage, die beim Kaschieren der Kartenschichten eines Kartenkörpers direkt mit diesem verbunden werden können. Es ist allerdings auch möglich, die Isolierschicht als thermoaktivierbare Klebeschicht auszubilden. In diesem Fall kann die Klebeschicht beim Einsetzen des Moduls in die Aussparung eines Kartenkörpers durch die Zuführung von Wärme aktiviert und damit das Modul mit dem Kartenkörper verbunden werden.

Wie in den Figuren angedeutet, liegt das Ausgangsprodukt als Endlosband bzw. als Mehrnutzenfilm vor. Die fertiggestellten Module müssen aus diesem Endlosband ausgestanzt werden. In den Figuren 6, 7 und 8 sind die Stanzkanten strichliniert dargestellt. Sie haben in allen Fällen die gleiche Lage, da sie unabhängig von der Größe des in das Modul einzubauenden Schaltkreises sind.

## Patentansprüche

1. Verfahren zur Herstellung eines elektronischen Moduls (2) für Datenträger (1) mit wenigstens einem integrierten Schaltkreis (22), mit einer elektrisch leitenden Schicht mit Kontaktflächen (15-20) für die Kommunikation des Schaltkreises mit externen Geräten und mit einer mit der leitenden Schicht verbundenen isolierenden Schicht (11), die zur elektrischen Verbindung (36; 44) der Kontaktflächen (15-20) mit dem Schaltkreis (22) Aussparungen (28) aufweist, **dadurch gekennzeichnet, daß**
- in einem ersten Schritt ein standardisiertes Ausgangsprodukt, bestehend aus einem Verbund der isolierenden Schicht (11) mit der elektrisch leitenden Schicht bereitgestellt wird, und
- in einem zweiten Schritt die Aussparungen (28) in die isolierende Schicht (11) eingebracht werden.

2. Verfahren zur Herstellung eines elektronischen Moduls nach Anspruch 1, **dadurch gekennzeichnet, daß** die Aussparungen (28) in der isolierenden Schicht (11) durch ein programmgesteuertes Werkzeug erstellt werden.

3. Verfahren zur Herstellung eines elektronischen Moduls nach den Ansprüchen 1 bis 2, **dadurch gekennzeichnet, daß** ein Fräswerkzeug oder ein Bohrwerkzeug verwendet wird, um die Aussparungen (28) in der isolierenden Schicht (11) zu erzeugen.

4. Verfahren zur Herstellung eines elektronischen Moduls nach Anspruch 3, **dadurch gekennzeichnet, daß** beim Erzeugen der Aussparungen (28) in der isolierenden Schicht (11) zum Teil in die Kontaktflächen (15-20) hineingefräst bzw. hineingebohrt wird.

5. Verfahren zur Herstellung eines elektronischen Moduls nach den Ansprüchen 1 bis 2, **dadurch gekennzeichnet, daß** ein Laser verwendet wird, um die Aussparungen (28) in der isolierenden Schicht (11) zu erzeugen.

6. Verfahren zur Herstellung eines elektronischen Moduls nach den Ansprüchen 1 bis 5, **dadurch, gekennzeichnet, daß** zusätzlich zu den Aussparungen (28) zur elektronischen Verbindung (36-44) der Kontaktflächen (15-20) mit dem Schaltkreis (22) Perforationen am Rande der isolierenden Schicht (11) erzeugt werden.

7. Verfahren zur Herstellung eines elektronischen Moduls nach den Ansprüchen 1 bis 5, **dadurch gekennzeichnet, daß** zusätzlich zu den Aussparungen (28) zur elektrischen Verbindung (36; 44) der Kontaktflächen (15-20) mit dem Schaltkreis (22) eine Aussparung (32) zur Aufnahme des integrierten Schaltkreises (22) in die isolierende Schicht (11) eingebracht wird.

8. Verfahren zur Herstellung eines elektronischen Moduls nach Anspruch 7, **dadurch gekennzeichnet, daß** zur Erstellung der Aussparung (32) zur Aufnahme des integrierten Schaltkreises (22) so tief in die isolierende Schicht (11) hineingefräst wird, daß nur ein dünner Boden (34) aus isolierendem Schichtmatieral verbleibt.

9. Verfahren zur Herstellung eines elektronischen Moduls nach Anspruch 7, **dadurch gekennzeichnet, daß** zur Erstellung der Aussparung (32) zur Aufnahme des integrierten Schaltkreises (22) zumindest bis auf das Kontaktlayout (26) gefräst wird.

10. Elektronisches Modul (2) für Datenträger (1) mit wenigstens einem integrierten Schaltkreis (22), mit einer elektrisch leitenden Schicht mit Kontaktflächen (15-20) für die Kommunikation des Schaltkreises (22) mit externen Geräten und mit einer mit der leitenden Schicht verbundenen isolierenden Schicht (11), die zur elektrischen Verbindung (36; 44) der Kontaktflächen (15-20) mit dem Schaltkreis (22) Aussparungen (28) aufweist, **dadurch gekennzeichnet, daß** die Aussparungen (28) zur elektrischen Verbindung (36; 44) der Kontaktflächen (15-20) mit dem Schaltkreis (22) zum Teil in die an die Aussparungen (28) angrenzenden Kontaktflächen (15-20) in der Weise hineinragen, daß die Kontaktflächen (15-20) in diesen Teilbereichen eine im Vergleich zur Dicke der leitenden Schicht verringerte Dicke aufweisen.

11. Elektronisches Modul nach Anspruch 10, **dadurch gekennzeichnet , daß** die Aussparungen (28) zur Hindurchführung der elektronischen Verbindung (36; 44) von den Kontaktflächen (15-20) zu dem Schaltkreis (22) derart ausgebildet sind, daß der im Zentrum des Moduls (2) verbleibende Bereich (34) der isolierenden Schicht (11) im wesentlichen nur die Chipfläche einnimmt.

12. Elektronisches Modul nach einem der Ansprüche 10 oder 11, **dadurch gekennzeichnet, daß** die isolierende Schicht (11) neben den Aussparungen (28) zur elektrischen Verbindung (36; 44) der Kontaktflächen (15-20) mit dem Schaltkreis (22) eine Aussparung (32) zur Aufnahme des integrierten Schaltkreises (22) enthält, deren Boden (34) den in die Aussparung (32) eingeklebten Schaltkreis (22) von dem auf der isolierenden Schicht (11) befindlichen Kontaktlayout (15-20; 26) trennt.

13. Elektronisches Modul nach Anspruch 12, **dadurch gekennzeichnet, daß** der Boden (34) veine Dicke von einigen µm aufweist.

14. Elektronisches Modul nach einem oder mehreren der Ansprüche 12 bis 13, **dadurch gekennzeichnet, daß** die Aussparung (32) zur Aufnahme des Schaltkreises (22) einen Rand aufweist, durch den die den Schaltkreis (22) und die leitenden Verbindungen (36; 44) umgebende Gußmasse (38) seitlich begrenzt ist.

## Claims

1. A method for producing an electronic module (2) for data carriers (1) with at least one integrated circuit (22), having an electrically conductive layer with contact surfaces (15-20) for communication of the circuit with external devices and having an insulating layer (11) which is connected with the conductive layer and has recesses (28) for electric connection (36; 44) of the contact surfaces (15-20) with the circuit (22), **characterized in that**
- a standardized starting product comprising a compound of the insulating layer (11) with the electrically conductive layer is provided in a first step, and
- the recesses (28) are provided in the insulating layer (11) in a second step.

2. A method for producing an electronic module according to claim 1, **characterized in that** the recesses (28) are produced in the insulating layer (11) by a program-controlled tool.

3. A method for producing an electronic module according to claims 1 to 2, **characterized in that** a milling cutter or drilling tool is used to produce the recesses (28) in the insulating layer (11).

4. A method for producing an electronic module according to claim 3, **characterized in that** one mills or drills partly into the contact surfaces (15-20) when producing the recesses (28) in the insulating layer (11).

5. A method for producing an electronic module according to claims 1 to 2, characterized in that a laser is used to produce the recesses (28) in the insulating layer (11).

6. A method for producing an electronic module according to claims 1 to 5, characterized in that perforations are produced at the edge of the insulating layer (11) in addition to the recesses (28) for electronic connection (36; 44) of the contact surfaces (15-20) with the circuit (22).

7. A method for producing an electronic module according to claims 1 to 5, characterized in that a recess (32) for taking up the integrated circuit (22) is provided in the insulating layer (11) in addition to the recesses (28) for electric connection (36; 44) of the contact surfaces (15-20) with the circuit (22).

8. A method for producing an electronic module according to claim 7, **characterized in that** one produces the recess (32) for taking up the integrated circuit (22) by milling into the insulating layer (11) deep enough that only a thin bottom (34) of insulating layer material remains.

9. A method for producing an electronic module according to claim 7, **characterized in that** one produces the recess (32) for taking up the integrated circuit (22) by milling at least as far as the contact layout (26).

10. An electronic module (2) for data carriers (1) with at least one integrated circuit (22), having an electrically conductive layer with contact surfaces (15-20) for communication of the circuit (22) with external devices and having an insulating layer (11) which is connected with the conductive layer and has recesses (28) for electric connection (36; 44) of the contact surfaces (15-20) with the circuit (22), **characterized in that** the recesses (28) for electric connection (36; 44) of the contact surfaces (15-20) with the circuit (22) protrude partly into the contact surfaces (15-20) adjacent the recesses (28) in such a way that the contact surfaces (15-20) have in these areas a reduced thickness compared to the thickness of the conductive layer.

11. An electronic module according to claim 10, **characterized in that** the recesses (28) for guiding through the electronic connection (36; 44) from the contact surfaces (15-20) to the circuit (22) are formed in such a way that the area (34) of the insulating layer (11) remaining in the center of the module (2) takes up substantially only the chip surface.

12. An electronic module according to either of claims 10 and 11, **characterized in that** the insulating layer (11) contains along with the recesses (28) for electric connection (36; 44) of the contact surfaces (15-20) with the circuit (22) a recess (32) for taking up the integrated circuit (22) whose bottom (34) separates the circuit (22) glued in the recess (32) from the contact layout (15-20; 26) located on the insulating layer (11).

13. An electronic module according to claim 12, **characterized in that** the bottom (34) has a thickness of a few microns.

14. An electronic module according to one or more of claims 12 to 13, **characterized in that** the recess (32) for taking up the circuit (22) has an edge which laterally limits the casting compound (38) surrounding the circuit (22) and the conductive connections (36; 44).

## Revendications

1. Procédé de fabrication d'un module électronique (2) pour un support de données (1) avec au moins un circuit intégré (22) avec une couche conductrice d'électricité avec des surfaces de contact (15 à 20) pour la communication entre le circuit intégré et des appareils externes et avec une couche isolante (11) liée à la couche conductrice, qui, pour la liaison électrique (36-44) des surfaces de contact (15-20) avec le circuit (22) présente des évidements (28), **caractérisé en ce que** :
- dans une première étape, on prépare un produit de départ standardisé composé d'un composite de la couche isolante (11) avec la couche conductrice d'électricité, et
- dans une deuxième étape, on pratique les évidements (28) dans la couche isolante (11).

2. Procédé de fabrication d'un module électronique selon la revendication 1, **caractérisé en ce que** les évidements (28) dans la couche isolante (11) sont produits au moyen d'un outil à commande par programme.

3. Procédé de fabrication d'un module électronique selon la revendication 1 ou 2, **caractérisé en ce qu'**on utilise un outil de fraisage ou de perçage pour pratiquer les évidements (28) dans la couche isolante (11).

4. Procédé de fabrication d'un module électronique selon la revendication 3, **caractérisé en ce que**, lors de la réalisation des évidements (28) dans la couche isolante (11), on réalise partiellement un fraisage ou un perçage des surfaces de contact (15-20).

5. Procédé de fabrication d'un module électronique selon la revendication 1 ou 2, **caractérisé en ce qu'**on utilise un laser pour pratiquer les évidements (28) dans la couche isolante (11).

6. Procédé de fabrication d'un module électronique selon les revendications 1 à 5, **caractérisé en ce que**, à part les évidements (28) pour la liaison électronique (36 ; 44) des surfaces de contact (15-20) avec le circuit (22), on pratique des perforations aux bords de la couche isolante (11).

7. Procédé de fabrication d'un module électronique selon les revendications 1 à 5, **caractérisé en ce que**, à part les évidements (28) pour la liaison électrique (36 ; 44) des surfaces de contact (15-20) avec le circuit (22), on pratique un évidemment (32) pour recevoir le circuit intégré (22) dans la couche isolante (11).

8. Procédé de fabrication d'un module électronique selon la revendication 7, **caractérisé en ce que**, afin de réaliser l'évidement (32) pour recevoir le circuit intégré (22) on pratique un fraisage jusqu'à une profondeur suffisante de la couche isolante (11) pour ne laisser qu'une base mince (34) composée de matériau de la couche isolante.

9. Procédé de fabrication d'un module électronique selon la revendication 7, **caractérisé en ce que**, afin de pratiquer l'évidement (32) pour la réception du circuit intégré (22), on pratique le fraisage au moins jusqu'à l'agencement des contacts (26).

10. Module électronique (2) pour support de données (1) avec au moins un circuit intégré (22), avec une couche conductrice d'électricité avec des surfaces de contact (15-20) pour la communication du circuit (22) avec des appareils externes et avec une couche isolante (11) liée à la couche conductrice, qui présente des évidements (28) pour la liaison électrique (36 ; 44) des surfaces de contact (15-20) avec le circuit (22), **caractérisé en ce que** les évidements (28) pour la liaison électrique (26 ; 44) des surfaces de contact (15-20) avec le circuit (22) présentent des évidements se prolongeant partiellement dans les surfaces de contact (15-20), limitant les évidements (28) d'une façon telle que les surfaces de contact (15-20) présentent, dans ces zones partielles, une épaisseur qui est réduite par rapport à l'épaisseur de la couche conductrice.

11. Module électronique selon la revendication 10, **caractérisé en ce que** les évidements (28) pour le passage de la liaison électronique (36 ;44) au circuit (22) à partir des surfaces de contact (15-20) au circuit (22) sont réalisés de sorte que la zone (34) de la couche isolante (11) au centre du module (2) n'accepte essentiellement que la surface de la puce électronique.

12. Module électronique selon l'une des revendications 10 ou 11, **caractérisé en ce que** la couche isolante (11), à part les évidements (28) pour liaisons électriques (36 ;44) des surfaces de contact (15-20) avec le circuit (22), présente un évidement (32) pour recevoir le circuit intégré (22) dont le fond (34) sépare le circuit (22) collé à l'intérieur de l'évidement (32) de l'agencement des contacts (15-20 ; 26) situés sur la couche isolante (11).

13. Module électronique selon la revendication 12, **caractérisé en ce que** le fond (34) présente une épaisseur de quelques µm.

14. Module électronique selon l'une ou plusieurs des revendications 12 à 13, **caractérisé en ce que** l'évidement (31) pour la réception du circuit (22) présente un bord, au moyen duquel la masse de coulée (38) entourant le circuit (22) et les liaisons conductrices (36-44) est limité latéralement.
